(19) **Europäisches Patentamt**
**European Patent Office**
**Office européen des brevets**

(11) **EP 1 777 556 B1**

(12) **EUROPEAN PATENT SPECIFICATION**

(45) Date of publication and mention of the grant of the patent:
**09.04.2008 Bulletin 2008/15**

(51) Int Cl.:
*G02B 3/14* *(2006.01)*   *G02B 26/02* *(2006.01)*

(21) Application number: **06255372.2**

(22) Date of filing: **18.10.2006**

(54) **Electrowetting system comprising electrolyte solution with high reliability**

Elektrobenetzungssystem mit Elektrolytlösung von hoher Zuverlässigkeit

Système d'électromouillage comprenant une solution électrolytique à haute fiabilité

(84) Designated Contracting States:
**AT BE BG CH CY CZ DE DK EE ES FI FR GB GR HU IE IS IT LI LT LU LV MC NL PL PT RO SE SI SK TR**

(30) Priority: **19.10.2005 KR 20050098493**

(43) Date of publication of application:
**25.04.2007 Bulletin 2007/17**

(73) Proprietor: **Samsung Electro-Mechanics Co., Ltd Suwon,**
**Kyungki-Do 443-743 (KR)**

(72) Inventors:
• **Bae, Jae Young**
**Central R&D Institute (No 2 Bldg 6F)**
**314 Maetan 3-dong**
**Yeongtong-gu**
**Suwon**
**Gyunggi-do (KR)**

• **Kim, Jong Yun**
**Youngtong-ku**
**Suwon**
**Kyungki-do (KR)**
• **Jung, Ha Yong**
**Suwon**
**Kyungki-do (KR)**
• **Shim, Ji Hye**
**Youngtong-ku**
**Suwon**
**Kyungki-do (KR)**

(74) Representative: **Dee, Ian Mark**
**Potter Clarkson LLP**
**Park View House**
**58 The Ropewalk**
**Nottingham NG1 5DD (GB)**

(56) References cited:
**WO-A-20/04099845      US-A1- 2003 227 100**

**Description**

BACKGROUND OF THE INVENTION

Field of the Invention

The present invention relates to an electrowetting system. More specifically, the present invention relates to an electrowetting system using an electrically conductive solution in which the type and concentration of salts included in the electrically conductive solution are adjusted to ensure reliability in the operational performance of the electrowetting system in terms of temperature variation of the conductive solution.

Description of the Related Art

Electrowetting is a phenomenon wherein the surface tension of a liquid is altered using electrical charges present at the interface of the liquid. The electrowetting phenomenon can be utilized to handle microliquids and microparticles present in liquids. A great deal of research has been concentrated on products based on the electrowetting phenomenon. The electrowetting phenomenon is currently utilized in a wide variety of applications, including liquid lenses, micropumps, display devices, optical devices and micro-electromechanical systems (MEMSs). Particularly, liquid lenses for auto focus (A/F) have the advantages of small size, reduced electric power consumption and high response rate in terms of their operational manner, compared to conventional liquid lenses.

Various factors, such as operational performance, optical performance, reproducibility, stability and reliability, must be taken into consideration in order to realize electrowetting systems. Particularly, when a voltage is applied to an electrowetting system, the shape of a liquid must be stably maintained without unstable trembling and moving at the interface of the liquid to achieve desired purposes. Further, an electrowetting system for use in micro-electromechanical systems (MEMSs) must have a low operating electric power and a high response rate. A material in a liquid state shows large variations in physical properties according to temperature variation. Accordingly, it is important to minimize the variations in the physical properties of a liquid of an electrowetting system according to temperature variation in order to ensure the reliability of the liquid.

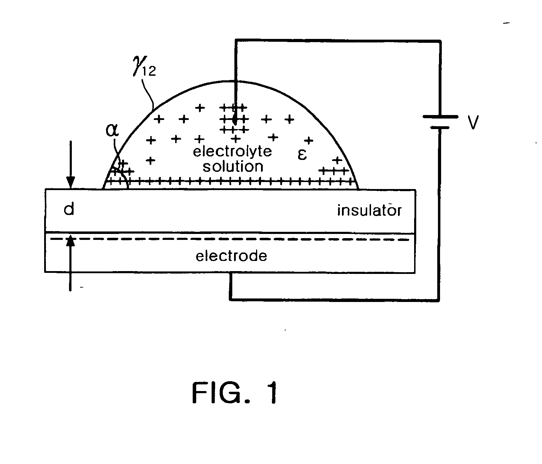

Electrowetting is a phenomenon wherein the surface tension of a liquid is altered using electrical charges present at the interface of the liquid to induce changes in the contact angle of the liquid. According to the electrowetting phenomenon, a high potential difference at the interface of a liquid is achieved when a thin insulator is present at the interface. FIG. 1 is a schematic diagram of a conventional electrowetting system.

Charges present in an electrolyte tend to move toward the boundaries of the electrolyte on account of their chemical properties. The tendency becomes stronger when an external voltage is applied to the electrolyte. Particularly, the concentration of the charges is greatly increased at triple contact lines (TCLs) where the boundaries overlap. This phenomenon brings about an increase in the repulsive force between the charges, resulting in lowering of surface tension at the edges of liquid droplets. This is expressed by the following relationship:

$$\frac{Surface\ force}{Volume\ force} \propto \frac{l^2}{l^3} = \frac{1}{l}$$

The electrowetting phenomenon can be utilized in a variety of application fields, such as rapid transportation, mixing and coating of microliquids, and optical switches. Recent research has been directed to the application of the electrowetting phenomenon to liquid lenses, micropumps, display devices, optical devices, MEMSs, and microliquids.

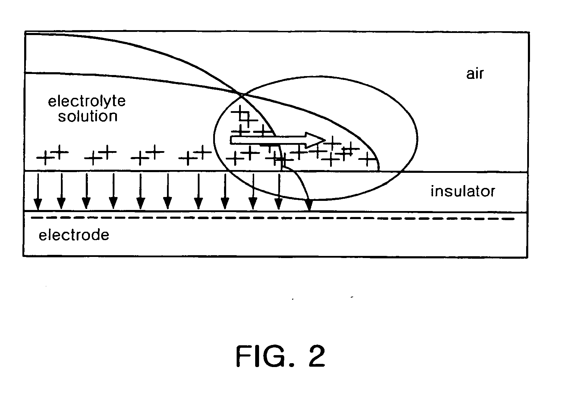

The production of an electrowetting system based on the electrowetting phenomenon essentially requires the use of one or more solutions. An electrically conductive solution (hereinafter, referred to as an "electrolyte solution") is particularly important because it possesses electrical properties and functions to substantially operate an electrowetting system. In general, an electrolyte solution for use in an electrowetting system contains pure water and a salt, *e.g.*, $Na_2SO_4$ or LiCl, serving to impart electrical properties to the pure water. FIG. 2 shows a state in which an electrolyte solution is moved in a general electrowetting system when a voltage is applied to the electrowetting system.

WO 2004/099845 describes an electrowetting module having the features of the preamble of claim 1 of the appended claims.

First, a droplet of the electrolyte solution is dropped on an insulator, which is coated on an electrode. Thereafter, when a voltage is applied to the electrode, charges present in the electrolyte solution migrate. This migration of the charges induces a phenomenon wherein the droplet of the electrolyte solution spreads on the surface of the insulator, as shown in FIG. 2.

For the application of this principle to micro-electromechanical systems, it is important to ensure superior reliability of the electrolyte solution. According to conventional electrowetting systems, salts are added to electrolyte solutions only for the purpose of imparting electrical properties to the electrolyte solution. In addition, according to conventional electrowetting systems, no attempt has been made to ensure reliability in terms of temperature variation of an electrolyte solution. Further, some electrowetting systems with superior optical performance have been developed by adding an organic solvent to an electrolyte solution to increase the difference in the refractive index of the liquids. These electrowetting systems show improved optical properties at room temperature, but do not ensure reliability in terms of temperature variation of the electrolyte solution.

For the application of an electrowetting system to a variety of electronic devices, it is important to ensure reliability of the electrowetting system in terms of temperature variation. General electronic devices are required to have operational reliability in the range of - 40°C to +85°C. Since a material in a liquid state undergoes great changes in physical properties, compared to a material in a solid state, such changes must be minimized so that they have little influence on the operational performance of an electrowetting system.

## SUMMARY OF THE INVENTION

It is one object of the present invention to provide an electrowetting system comprising an electrolyte solution, which is in a liquid state undergoing great changes in physical properties according to temperature variation, whose characteristics are controlled to minimize changes in physical properties and whose reliability is ensured in terms of temperature variation by optimizing the type and concentration of salts included in the electrolyte solution.

In accordance with an aspect of the present invention for achieving the above object, there is provided an electrowetting system comprising an electrolyte solution and optionally a non-conductive liquid (hereinafter, referred to as an 'insulating solution') wherein the electrolyte solution includes a first salt having a molar mass of 100 or below and a solubility of 27g or above in 100g of water, a second salt (a chaotropic salt) containing an ion with a negative Jones-Dole coefficient (B), a third salt containing an ion with a Setschenow constant ($k_s$) of 0.150 or above, the first, second and third salts being different. Preferably the salts are in the range of 10 to 30% by weight with respect to the total weight of the electrolyte solution.

## BRIEF DESCRIPTION OF THE DRAWINGS

The above objects, features and other advantages of the present invention will be more clearly understood from the following detailed description taken in conjunction with the accompanying drawings, in which:

FIG. 1 is a schematic diagram showing the structure of a general electrowetting system;
FIG. 2 is a diagram schematically showing a state of an electrowetting system in which an electrolyte solution is moved when a voltage is applied to the electrowetting system;
FIG. 3 shows changes in the curvature of an interface between an electrolyte solution and an insulating solution of an electrolyte system when a voltage is applied to the electrolyte system; and
FIG. 4 is a graph showing changes in the viscosity of water as a function of temperature.

## DETAILED DESCRIPTION OF THE INVENTION

The present invention will now be described in greater detail.

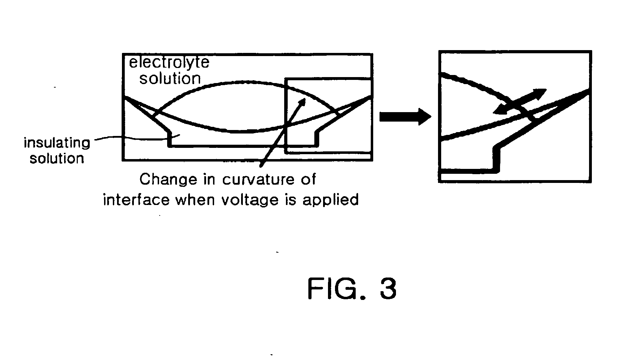

FIG. 3 shows a state in which an electrolyte solution of a liquid lens is moved when a voltage is applied to the liquid lens. The liquid lens comprises two kinds of immiscible solutions, i.e. i) an electrolyte solution possessing electrical properties and functioning to substantially operate the liquid lens and ii) a non-conductive oil or liquid (hereinafter, referred to as an 'insulating solution') whose shape is relatively changed depending on the movement of the electrolyte solution to function as a lens, which are separated by an interface formed therebetween.

The electrolyte solution of the electrowetting system according to the present invention includes a first salt having a molar mass of 100 or below and a solubility of 27g or above in 100g of water.

In general, the addition of a salt to water causes changes in physical properties of the water. For example, a salt added to water increases the density of the aqueous solution, and lowers the freezing point of the aqueous solution in proportion to the molar concentration of the salt. In the case of an electrolyte solution for a liquid lens, an excess of a salt must be added to prevent the electrolyte solution from freezing at low temperature. For example, one or more moles of a salt must be added to 100g of water in order to prevent the aqueous solution from freezing at -40°C. Table 1 shows the molar mass and solubility of various soluble salts that may be added to an electrolyte solution of an electrowetting system, according to increasing size of the molar mass.

**TABLE 1**

| Salt | Molar mass | Solubility (0°C, 100g) | Salt | Molar mass | Solubility (0°C, 100g) |
|---|---|---|---|---|---|
| LiCl | 42.4 | 67.0 | $CaCl_2$ | 111.0 | 59.5 |
| $NH_4Cl$ | 53.5 | 29.4 | KBr | 119.0 | 53.5 |
| NaNl | 58.4 | 35.7 | $MgSO_4$ | 120.4 | 26.0 |
| KCl | 74.6 | 27.6 | $Na_2SO_4$ | 142.0 | 4.8 |
| $NaNO_3$ | 85.0 | 73.0 | $CuSO_4$ | 159.6 | 19.2 |
| $KNO_3$ | 101.1 | 13.3 | $K_2SO_4$ | 174.3 | 7.35 |

Most silicon oil-based materials that may constitute an insulating solution of a liquid lens have a density of 1.0 or below. A requirement for a liquid lens is that an electrolyte solution must have the same density as an insulating solution. Thus, a salt having a relatively low molar mass is preferred because it can minimize the density of an electrolyte solution. A salt having a molar mass of 100 or below and a solubility of 27 or above in 100g of water is preferably used in the electrolyte solution of the electrowetting system according to the present invention because it can minimize the density of the electrolyte solution to allow the electrolyte solution to have the same density as the insulating solution and can prevent the electrolyte solution from freezing at a temperature of -40°C.

Referring to Table 1, LiCl, $NH_4Cl$, NaCl and KC1 are included in salts having a molar mass of 100 or below and a solubility of 27 or above in 100g of water.

The electrolyte solution of the electrowetting system according to the present invention includes a chaotropic salt containing an ion with a negative Jones-Dole coefficient.

When a salt is added to water, the viscosity of the aqueous solution can be represented by the following equation 1:

## EQUATION 1

$$\frac{\eta}{\eta_0} = 1 + A\,c^{1/2} + Bc + \ldots\ldots$$

$\eta$: Viscosity of aqueous solution containing salt
$\eta_0$: Viscosity of pure water
c: Concentration of salt
A: Debye-Huckel constant
B: Jones-Dole coefficient

Ions may be classified into kosmotropic ions and chaotropic ions by their Jones-Dole coefficient (B). Specifically, kosmotropic ions have a positive Jones-Dole coefficient (B), and chaotropic ions have a negative Jones-Dole coefficient (B).

An ion (i.e. a chaotropic ion) having a negative Jones-Dole coefficient (B) added to an electrolyte solution impedes structural bonding of water molecules. As a result, the number of hydrogen bonds between the water molecules is reduced and the viscosity of the aqueous solution (i.e. the electrolyte solution) is decreased. These results cause only a slight change in the viscosity of the aqueous solution with varying temperatures. Accordingly, a chaotropic salt is preferably used in the electrolyte solution of the electrowetting system according to the present invention.

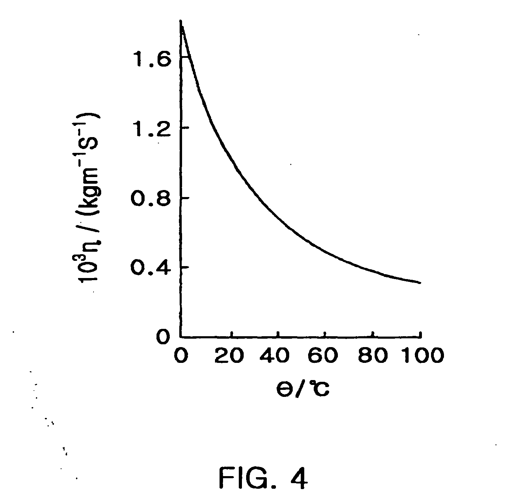

Meanwhile, an ion (i.e. a kosmotropic ion) having a positive Jones-Dole coefficient (B) added to an electrolyte solution of an electrowetting system enhances structural arrangement of water molecules around the ion and is strongly bound to the water molecules. As a result, the viscosity of the aqueous solution (i.e, the electrolyte solution) is increased. If the viscosity of an electrolyte solution is too low, an electrowetting system comprising the electrolyte solution suffers from surface trembling when a voltage is applied to the electrowetting system. Accordingly, it is preferred that the aqueous solution has a higher viscosity than pure water in order to stably operate the system. On the other hand, the viscosity of water increases with decreasing temperature. The reason for this behavior of water is that water molecules are uniformly arranged and the number of hydrogen bonds between the water molecules is increased at low temperature, thus creating a strong binding force between the water molecules. As shown in FIG. 4, as the temperature of water decreases, the viscosity of the water increases exponentially. If the viscosity of water is higher than that required for the stabilization of the interface of an electrolyte solution at low temperature, slow movement of the electrolyte solution is caused. Accordingly, the use of a kosmotropic salt in the electrolyte solution of the electrowetting system according to the present invention is not preferred.

As described above, it is preferred that an electrolyte solution has a higher viscosity than pure water. However, a soluble salt added to an electrolyte solution generates an electrical binding force between the ions of the salt and the water molecules to arrange the water molecules. Since this arrangement of the water molecules renders the bonding between the water molecules strong or weak, the viscosity of the aqueous solution may be changed. That is, the addition of a polar solvent is effective in ensuring interfacial stabilization. Accordingly, a salt capable of lowering changes in the viscosity of the aqueous solution according to temperature variation is preferably used to ensure low-temperature operational reliability of the electrowetting system according to the present invention.

In general, ions having a small size and a high electrical charge, *i.e.* ions (for example, $Li^+$, $Mg^{2+}$, $Ca^{2+}$ and F) having a high surface charge density, belong to kosmotropic ions, and ions (for example, $Cs^+$, $Br^-$ and $I^-$) having a low surface charge density belong to chaotropic ions. In addition, diatomic ions, such as $NH_4^+$ and $NO_3^-$, can act as chaotropic ions, due to their low surface charge density.

The chaotropic ions shown in Table 1 are effective in reducing the viscosity of an electrolyte solution. In particular, ions, such as $K^+$, $Cl^-$ and $I^-$, tend to have a small Jones-Dole coefficient with decreasing temperature. Accordingly, the use of a salt containing an ion with a negative Jones-Dole coefficient in the electrolyte solution of the electrowetting system according to present invention guarantees low-temperature operational reliability of the electrowetting system.

Tables 2 and 3 show changes in physical properties and freezing point of aqueous solutions having different LiCl concentrations, respectively. LiCl is frequently used as an electrolyte for an electrolyte solution due to its small size and high solubility. From the tables, it can be confirmed that as the salt concentration increases, the density, viscosity, refractive index and surface tension of the aqueous solutions tend to increase. The increase in the viscosity and refractive index of the aqueous solutions indicate that $Li^+$ ions act as kosmotropic ions to increase the binding force between the water molecules. In the case where no additive (such as, an antifreezing solution) is used in the electrolyte solutions, the LiCl concentration must be maintained at 20% or above in order to prevent the electrolyte solutions from freezing at low temperature, so that low-temperature operational reliability of the electrolyte solutions can be achieved.

**TABLE 2**

| No. | Electrolyte solution | Density (g/cm$^3$) | Viscosity (mPa•s) | Refractive index (nD$^{20}$) | Surface tension (mN/m) |
|---|---|---|---|---|---|
| 1 | H$_2$O 100% LiCl 0% | 1.000 | 1.4 | 1.3329 | 70.9 |
| 2 | H$_2$O 99% LiCl 1% | 1.006 | 1.2 | 1.3350 | 71.3 |
| 3 | H$_2$O 90% LiCl 10% | 1.055 | 2.4 | 1.3538 | 74.7 |
| 4 | H$_2$O 80% LiCl 20% | 1.105 | 2.8 | 1.3716 | 79.2 |
| 5 | H$_2$O 70% LiCl 30% | 1.154 | 4.8 | 1.3890 | 84.2 |

**TABLE 3**

| Sample | Freezing point (°C) | After standing at low temperature | | | |
|---|---|---|---|---|---|
| | | -10°C | -20°C | -30°C | -40°C |
| 5% LiCl | - | Frozen | Frozen | Frozen | Frozen |
| 10% LiCl | -29.6 | Not Frozen | Frozen | Frozen | Frozen |
| 15% LiCl | -45.5 | Not Frozen | Not Frozen | Frozen | Frozen |
| 20% LiCl | -54.7 | Not Frozen | Not Frozen | Not Frozen | Not Frozen |

However, in order to solve slow movement of the aqueous solutions, which results from the increased viscosity of the aqueous solutions at low temperature, it is more preferred to use a salt containing a chaotropic ion, such as KC1, KBr, $NH_4Cl$ or $KNO_3$, rather than LiCl. However, since the salt has a high molar mass, it increases the density of the aqueous solution and is poorly water-soluble. Accordingly, when the salt is added in an excessive amount, it may form a precipitate at low temperature.

In conclusion, a mixture of LiCl having a low molar mass and a high solubility and a chaotropic salt capable of reducing the viscosity of an electrolyte solution for a liquid lens at low temperature in an appropriate ratio can be used to satisfy all physical properties, such as freezing point, density and low-temperature operation, required for the electrolyte solution, thus achieving better operational characteristics of the liquid lens.

The chaotropic salt is a salt having a negative Jones-Dole coefficient, and specific examples thereof include $Cs^+$, $Br^-$, $I^-$, $K^+$, $Cl^-$, $NH_4^+$ and $NO_3^-$. The chaotropic salt serves to minimize changes in the viscosity of an electrolyte solution according to temperature variation, i.e. an increase in the viscosity of an electrolyte solution according to a decrease in temperature, so that low-temperature operational reliability of the electrolyte solution can be ensured.

The electrolyte solution of the electrowetting system according to the present invention includes a salt containing an ion with a Setschenow constant ($k_s$) of 0.150 or above.

A salt added to an aqueous solution causes a reduction in the solubility of non-polar molecules in the aqueous solution, thus accelerating the separation of the non-polar molecules from the aqueous solution. This phenomenon is called a "Hofmeister effect", which is represented by the following Setschenow equation:

$$\ln\left[\frac{c_i}{c_i(0)}\right] = -k_s c_s$$

$c_i$: molar solubility of non-polar molecules in aqueous solution containing salt
$c_i(0)$: molar solubility of non-polar molecules in pure water
$c_s$: molar concentration of salt
$k_s$: Setschenow constant

An ion having a higher positive Setschenow constant ($k_s$) better separates the non-polar molecules from the aqueous solution and inhibits mixing between the electrolyte solution and an insulating solution at high temperature, thus ensuring high-temperature reliability of the electrolyte solution. In general, the smaller the size of an ion (except $Li^+$), the higher the constant ($k_s$) of the ion (See Table 4). It is important to inhibit occurrence of physical mixing and chemical reactions between an electrolyte solution and an insulating solution of a liquid lens, particularly at high temperature, where molecules contained in the solutions are actively moved, in order to operate the liquid lens. To this end, the addition of an ion having a large $k_s$ value is effective in attaining the desired effects. More specifically, an ion having a $k_s$ value of 0.150 or above is preferably added to the electrolyte solution of the electrowetting system according to the present invention.

**TABLE 4**

| Ion | $Li^+$ | $Na^+$ | $K^+$ | $Cs^+$ | $Ba^{2+}$ | $F^-$ | $Cl^-$ | $Br^-$ | $I^-$ |
|---|---|---|---|---|---|---|---|---|---|
| $k_s$ ($dm^3$/mol) | 0.141 | 0.195 | 0.166 | 0.088 | 0.334 | 0.254 | 0.195 | 0.155 | 0.095 |

Table 4 shows relative $k_s$ values of various ions with respect to the $k_s$ value of benzene. As can be seen from the data shown in Table 4, $Na^+$, $K^+$, $Ba^{2+}$, $F^-$, $Cl^-$ and $Br^-$ are ions having a $k_s$ value greater than 0.150.

A salt containing $Ba^{2+}$ or $F^-$, which is an ion having a $k_s$ value higher than 0.150, has a great ability to salt out non-polar molecules, but it has a low solubility. This low solubility makes the salt unsuitable for use in an electrolyte solution of a liquid lens, which requires the use of an excessive amount of the salt.

Assuming that the physical properties of silicon oil commonly used as an insulating solution are not significantly different from those of benzene, NaCl is the most efficient salt for the separation of the electrolyte solution from the insulating solution.

In conclusion, when the above-mentioned factors (e.g., solubility, freezing point, changes in viscosity according to temperature variation, and separation of an insulating solution from an electrolyte solution) are taken into consideration, a mixture including a salt having a low molar mass and a high solubility, a salt containing a chaotropic ion with a low charge density (i.e. a salt containing an ion with a negative Jones-Dole coefficient (B)) and a salt containing an ion with a great salting-out ability (i.e. a salt containing an ion with a Setschenow constant ($k_s$) of 0.150 or above), in an appropriate mixing ratio can be used to design an electrolyte solution satisfying the physical properties and reliability required in an electrowetting system.

As apparent from the foregoing, a mixture of some kinds of salts having different inherent characteristics, i.e. a salt having a low molar mass and a high solubility, a salt containing a chaotropic ion with a low charge density and a salt containing an ion with a great salting-out ability, is used as an electrolyte solution of the electrowetting system according to the present invention. Taking into consideration all factors, such as solubility, freezing point, changes in viscosity according to temperature variation and separation from an insulating solution from the electrolyte solution, the electrolyte solution satisfies reliability in terms of temperature variation.

**Claims**

1. An electrowetting system comprising an electrolyte solution wherein the electrolyte solution includes a first salt having a molar mass of 100 or below and a solubility of 27g or above in 100g of water, **characterised in that** the electrolyte solution further includes a second, chaotropic salt containing an ion with a negative Jones-Dole coefficient (B), and a third salt containing an ion with a Setschenow constant ($k_s$) of 0.150 or above, said first, second and third salts being different.

2. The electrowetting system according to claim 1, wherein the salts are in the range of 10 to 30% by weight, based on the total weight of the electrolyte solution.

3. The electrowetting system according to claim 1, wherein the first salt is selected from the group consisting of LiCl, $NH_4Cl$, NaCl, and KCl.

4. The electrowetting system according to claim 1, wherein the second salt contains an ion selected from the group consisting of $Cs^+$, $Br^-$, $I^-$, $K^+$. $Cl^-$, $NH_4^+$, and $NO_3^-$.

5. The electrowetting system according to claim 1, wherein the third salt contains an ion selected from the group consisting of $Na^+$, $K^+$, $Cl^-$, and $Br^-$.

6. The electrowetting system according to any one of claims 1 to 5, further comprising an insulating solution.

**Patentansprüche**

1. Elektrobenetzungssystem, umfassend eine Elektrolytlösung, wobei die Elektrolytlösung ein erstes Salz mit einer Molmasse von 100 oder weniger und einer Löslichkeit von 27 g oder mehr in 100 g Wasser aufweist, **dadurch gekennzeichnet, dass** die Elektrolytlösung ferner ein zweites chaotropes Salz, das ein Ion mit einem negativen Jones-Dole-Koeffizienten (B) enthält, und ein drittes Salz aufweist, das ein Ion mit einer Setschenow-Konstante ($k_s$) von 0,150 oder mehr enthält, wobei das erste, zweite und dritte Salz verschieden sind.

2. Elektrobenetzungssystem nach Anspruch 1, wobei die Salze basierend auf dem Gesamtgewicht der Elektrolytlösung im Bereich von 10 bis 30 Gew.-% liegen.

3. Elektrobenetzungssystem nach Anspruch 1, wobei das erste Salz ausgewählt ist aus der Gruppe, bestehend aus LiCL $NH_4Cl$, NaCl und KC1.

4. Elektrobenetzungssystem nach Anspruch 1, wobei das zweite Salz ein Ion enthält, das ausgewählt ist aus der Gruppe, bestehend aus $Cs^+$, $Br^-$, $I^-$, $K^+$, $Cl^-$, $NH_4^+$ und $NO_3^-$.

5. Elektrobenetzungssystem nach Anspruch 1, wobei das dritte Salz ein Ion enthält, das ausgewählt ist aus der Gruppe, bestehend aus $Na^+$, $K^+$, $Cl^-$ und $Br^-$.

6. Elektrobenetzungssystem nach einem der Ansprüche 1 bis 5, ferner umfassend eine Isolierlösung.

**Revendications**

1. Système d'électromouillage comprenant une solution électrolytique dans lequel la solution électrolytique comprend un premier sel ayant une masse molaire de 100 ou moins et une solubilité de 27 g ou plus dans 100 g d'eau, **caractérisé en ce que** la solution électrolytique comprend en outre un deuxième sel chaotropique contenant un ion avec un coefficient de Jones-Dole négatif (B), et un troisième sel contenant un ion avec une constante de Setschenow ($K_s$) de 0,150 ou plus, lesdits premier, deuxième et troisième sels étant différents.

2. Système d'électromouillage selon la revendication 1, dans lequel les sels sont dans la plage de 10 à 30 % en poids, sur la base du poids total de la solution électrolytique.

3. Système d'électromouillage selon la revendication 1, dans lequel le premier sel est sélectionné dans le groupe constitué de LiCl, $NH_4Cl$, NaCl et KCl.

4. Système d'électromouillage selon la revendication 1, dans lequel le deuxième sel contient un ion choisi dans le groupe constitué de $Cs^+$, $Br^-$, $I^-$, $K^+$, $Cl^-$, $NH_4^+$ et $NO_3^-$.

5. Système d'électromouillage selon la revendication 1, dans lequel le troisième sel contient un ion sélectionné dans le groupe constitué de $Na^+$, $K^+$, $Cl^-$ et $Br^-$.

6. Système d'électromouillage selon l'une quelconque des revendications 1 à 5, comprenant en outre une solution isolante.

$\gamma_{12}$

$\alpha$

$+$ $+$ $+$ $+$ $+$ $+$
$+$ $+$ $+$ $+$ $+$
electrolyte $\varepsilon$
solution
$+$ $+$

d

insulator

electrode

V

## FIG. 1

FIG. 2

electrolyte
solution

insulating
solution

Change in curvature of
interface when voltage is applied

FIG. 3

FIG. 4

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 2004099845 A